# EUROPÄISCHE PATENTANMELDUNG

(11) **EP 4 160 462 A1**
(43) Veröffentlichungstag der Anmeldung: **05.04.2023**
(21) Anmeldenummer: 21199820.8
(22) Anmeldetag: 29.09.2021
(51) Int. Cl.: G06F 30/13, G06F 30/20

(54) **LAYOUTOPTIMIERUNG FÜR FABRIKEN**

(71) Anmelder: Siemens Aktiengesellschaft, 80333 München (DE)
(72) Erfinder: Klein, Daniel, 92280 Kastl (DE); Petri, Florian, 90489 Nürnberg (DE)
(74) Vertreter: Siemens Patent Attorneys

(57) **Zusammenfassung**

Die Erfindung betrifft ein Verfahren zur Optimierung eines Layouts einer Fabrik. Die Erfindung betrifft weiter ein Computerprogramm zur Durchführung eines derartigen Verfahrens sowie ein Computerprogrammprodukt mit einem derartigen Computerprogramm. Um ein im Vergleich zum Stand der Technik verbessertes Verfahren zur Optimierung eines Layouts einer Fabrik anzugeben, das insbesondere die Nachteile bisheriger Verfahren bei einer großen Produkt- und/oder Materialvarianz reduziert, wird ein Verfahren vorgeschlagen, wobei die Produkte zumindest eine erste Eigenschaft aufweisen, die als Zeichenkette darstellbar ist, wobei die Produkte durch jeweils einen Datenpunkt in Abhängigkeit von zumindest der ersten Eigenschaft repräsentiert werden, wobei zumindest eine erste maximale Distanz von einem Datenpunkt in Abhängigkeit von zumindest der ersten Eigenschaft festgelegt wird, wobei die Datenpunkte zumindest anhand der ersten maximalen Distanz in Cluster eingeteilt werden, wobei von zumindest einem Cluster zumindest ein Datenpunkt als Vertreter für den jeweiligen Cluster ausgewählt wird und wobei anhand zumindest eines Vertreters das Layout in Bezug auf zumindest einen Parameter optimiert wird.

## Beschreibung

Die Erfindung betrifft ein Verfahren zur Optimierung eines Layouts einer Fabrik. Die Erfindung betrifft weiter ein Computerprogramm zur Durchführung eines derartigen Verfahrens sowie ein Computerprogrammprodukt mit einem derartigen Computerprogramm.

Ein derartiges Verfahren kommt auf dem Gebiet der industriellen Fertigung zum Einsatz. Die Layoutoptimierung von Fabriken ist heutzutage mit einem digitalen Zwilling eine häufig praktizierte Methode. Allerdings eignet sich diese vor allem für Fabriken mit einem gewissen Automatisierungsgrad und Serienfertigung von vielen gleichen bzw. ähnlichen Teilen. Bei Fertigungen mit vielen manuellen Schritten, die den Leitsatz "high mixture - low volume" verfolgen, ist die Abstraktion in ein digitales Modell aufgrund der hohen Produkt- und Materialvarianz extrem zeitintensiv und fehleranfällig. Deshalb wird in solchen Fällen oft nur ein kleiner Teil der Produkte untersucht und das Finden eines günstigen Fabriklayouts ist immens schwierig aufgrund der hohen Produktvarianz. Allerdings werden so wichtige Zusammenhänge und Abläufe in der Fertigung ausgeschlossen.

Bisher wurden die Produkte beispielsweise in Excel-Tabellen nach bestimmten Kriterien in Gruppen eingeteilt. Diese sind z.B. Einsatzzweck oder Fertigungsmenge pro Jahr. Danach wurden aus diesen Gruppen Referenzprodukte gesucht, die die Gruppe möglichst gut abbilden sollen und als Grundlage für die Layouterstellung bzw. -optimierung verwendet. Allerdings spiegeln diese Referenzprodukte die gesamte Produktvielfalt meist schlecht wider.

Anschließend wurde der digitale Zwilling nur auf diese begrenzte Anzahl Referenzprodukte analysiert und optimiert. Dabei kann die Kombination von Simulationsmodell und Optimierungsalgorithmen verwendet werden. Allerdings entstehen dann Ergebnisse auf unvollständiger Datenbasis, die die Realität zum Teil schlecht abbilden.

Auf der anderen Seite ist es möglich, beim Erstellen / Optimieren und Analysieren der Fabrik mittels eines digitalen Zwillings (z.B. in Plant Simulation) alle vom Auftraggeber gelieferten Daten zu berücksichtigen und bestmöglich ins Modell zu laden. Das aber ist sehr zeitintensiv, da sich der Simulationsexperte hauptsächlich um die Daten kümmern muss und weniger um den eigentlichen Hauptteil der Analyse und Optimierung der Fabrik mittels eines Simulationsmodells.

Der Erfindung liegt die Aufgabe zugrunde, ein im Vergleich zum Stand der Technik verbessertes Verfahren zur Optimierung eines Layouts einer Fabrik anzugeben, das insbesondere die Nachteile bisheriger Verfahren bei einer großen Produkt- und/oder Materialvarianz reduziert.

Diese Aufgabe wird gelöst durch ein Verfahren zur Optimierung eines Layouts einer Fabrik, in der Produkte hergestellt werden, wobei die Produkte zumindest eine erste Eigenschaft aufweisen, die als Zeichenkette darstellbar ist, wobei die Produkte durch jeweils einen Datenpunkt in Abhängigkeit von zumindest der ersten Eigenschaft repräsentiert werden, wobei zumindest eine erste maximale Distanz von einem Datenpunkt in Abhängigkeit von zumindest der ersten Eigenschaft festgelegt wird, wobei die Datenpunkte zumindest anhand der ersten maximalen Distanz in Cluster eingeteilt werden, wobei von zumindest einem Cluster zumindest ein Datenpunkt als Vertreter für den jeweiligen Cluster ausgewählt wird und wobei anhand zumindest eines Vertreters das Layout in Bezug auf zumindest einen Parameter optimiert wird.

Die Aufgabe wird weiter gelöst durch ein Computerprogramm bzw. Computerprogrammprodukt mit den in den Ansprüchen 11 bzw. 12 angegebenen Merkmalen.

Produkten können, abhängig von ihrem Weg durch die Fabrik im Verlauf ihrer Herstellung, gewisse Eigenschaften zugewiesen werden, die sich - anders als physikalische Messgrößen - nicht als numerische Werte, sondern als Zeichenketten darstellen lassen. Anhand dieser Eigenschaften können die Produkte nun nach Ähnlichkeit geclustert und für die Layoutoptimierung aus jedem Cluster zumindest ein (möglichst typischer) Vertreter ausgewählt werden. Die Optimierung selbst erfolgt dann nach herkömmlichen Methoden anhand zumindest eines Parameters wie beispielsweise Anzahl der Werker, Maschinen und/oder AGVs ("Automated Guided Vehicles"), die Produktreihenfolge und/oder die Maschinenanordnung.

Zur Bestimmung der Ähnlichkeit werden die Produkte anhand zumindest einer ersten Eigenschaft, die als Zeichenkette darstellbar ist, durch jeweils einen Datenpunkt repräsentiert. Als ähnliche Produkte werden nun solche bestimmt, deren Datenpunkt sich innerhalb zumindest einer ersten maximalen Distanz vom Datenpunkt eines anderen Produktes befindet. Dabei können auch mehrere Eigenschaften zur Bestimmung der Ähnlichkeit herangezogen werden, und es können natürlich auch mehrere maximale Distanzen im mehrdimensionalen Datenraum für die Clusterung verwendet werden. Im einfachsten Fall genügt die Verwendung einer ersten maximalen Distanz, und es werden - ausgehend von einem Datenpunkt - alle Produkte als ähnlich betrachtet und in einem Cluster zusammengefasst, die sich innerhalb dieser Distanz befinden. Der Ausgangspunkt kann dabei quasi beliebig gewählt werden, solange er sich noch nicht in einem Cluster befindet. Es können auch Cluster gebildet werden von Datenpunkten, die sich in einer Dimension innerhalb der ersten maximalen Distanz und in einer anderen Dimension innerhalb der zweifachen maximalen Distanz befinden. Nach Bildung der Cluster wird aus jedem Cluster zumindest ein Vertreter ausgewählt, anhand dessen die Optimierung erfolgt. Der Vertreter kann beispielsweise der Ausgangspunkt oder auch mehrere Datenpunkte etwa in der Mitte des Clusters sein.

Ergebnis sind unterschiedliche Produktcluster mit sehr ähnlichen Eigenschaften, von denen die "wichtigsten" herausgefiltert (ausgewählt) werden und anschließend als Basis für die Auslegung der neuen Fertigung dienen. Beispielsweise über ein Simulationsmodell wird dann versucht, die neue Fertigung möglichst passend auf diese Produktcluster anzupassen, wobei diese Optimierungsaufgabe durch Clusteralgorithmen unterstützt werden sollte. So kann mit sehr wenig Datenverlusten die Fertigung simuliert werden, da sich die anderen Produkte in einem Cluster aufgrund der ähnlichen Eigenschaften sehr ähnlich verhalten würden.

Das Clustering durch den oben erläuterten Algorithmus erfolgt je nach Datengröße im Sekunden- oder Minutenbereich, wohingegen ein Mensch zum Sortieren und Gruppieren der Daten Tage benötigt. Somit ist eine enorme Zeitersparnis zu verzeichnen. Außerdem kann das Clustering mit der erfindungsgemäßen Lösung mit unterschiedlichen Parameterwerten, z.B. für die erste maximale Distanz, ausgeführt werden. So ist es möglich, Vergleiche zu starten und ein Optimum zu suchen.

Für einen Menschen ist es mit realistischem Aufwand nur möglich, die Produkte nach einem Kriterium zu gruppieren. Die erfindungsgemäße Lösung kann eine beliebig große Anzahl von Kriterien berücksichtigen. Es ist weiter eine große Zeitersparnis gegenüber der Simulation mit allen Daten zu erreichen. Zum einen bei der Simulationszeit an sich, da weniger Produkte berücksichtigt werden, zum anderen aber vor allem beim Modellieren, da viele Produkte erst gar nicht berücksichtigt werden müssen, da sie von ähnlichen Produkten aus ihren Clustern vertreten werden.

Es wird so eine standardisierte Methode geschaffen, die es erleichtert, mittels eines digitalen Zwillings das Layout einer Fabrik zu optimieren, ohne alle Rohdaten berücksichtigen zu müssen. Das spart dem Simulateur enorm viel Zeit, da er den Fokus aufs Modellieren und Analysieren des Modells legen kann und nicht die Daten sortieren muss.

In einer vorteilhaften Form der Ausgestaltung wird eine minimale Anzahl von Datenpunkten festgelegt, die ein Cluster aufweisen muss. Datenpunkte, die gemäß der Regel zur Einteilung in Cluster anhand der ersten maximalen Distanz keine Nachbarn oder weniger als die minimale Anzahl von Datenpunkten haben, werden als "Noise" bzw. Rauschen deklariert und für die weitere Optimierung also nicht verwendet.

In einer weiteren vorteilhaften Ausführungsform wird zumindest die erste maximale Distanz als eine Levenshtein-Distanz oder eine Damerau-Levenshtein-Distanz definiert. Die Levenshtein-Distanz gibt an, wie viele Buchstabenoperationen nötig sind, um eine Zeichenkette in eine zweite umzuwandeln. Als Operationen stehen Einfügen, Löschen und Ersetzen einzelner Buchstaben zur Auswahl. Als Beispiel soll "Tier" zu "Tor" werden. Dazu kann das "i" durch ein "o" ersetzt und das "e" gelöscht werden. Somit sind zwei Schritte nötig und die Levenshtein-Distanz ist gleich 2. Die Damerau-Levenshtein-Distanz erweitert diesen Ansatz um das Tauschen zweier Buchstaben. Damit werden für das Umwandeln von "ca" in "abc" nur zwei Schritte benötigt: "ca" tauschen in "ac" und anschließend ein "b" einfügen ergibt "abc". Wird das gleiche Beispiel mit der Levenshtein-Distanz betrachtet, sind drei Schritte nötig: "c" löschen ergibt "a", "b" hinzufügen ergibt "ab", schließlich "c" hinzufügen ergibt "abc".

Für das Produktclustering werden die Buchstaben aus dem obigen Beispiel durch die Eigenschaften der Produkte ausgetauscht, die als Zeichenketten darstellbar sind. Herkömmliche Clusteralgorithmen (z.B. DBSCAN, "Density-Based Spatial Clustering of Applications with Noise") verwenden zur Abstandsbestimmung in der Regel die Euklid-Distanz. Hier soll allerdings nach nicht-physikalischen Eigenschaften geclustert werden, was bedeutet, dass die einfache Distanzmessung mit der Euklid-Distanz nicht möglich ist, da sie nur für Gleitkommazahlen funktioniert. Für die Eigenschaften von Produkten, die als Zeichenketten darstellbar sind, wird also ein anderes Verfahren zur Bestimmung der Ähnlichkeiten benötigt. Die Levenshtein- bzw. die Damerau-Levenshtein-Distanz ist hierfür sehr gut geeignet.

In einer weiteren vorteilhaften Ausführungsform wird das Layout in einem digitalen Abbild der Fabrik dargestellt. Mit der durch die erfindungsgemäße Lösung deutlich übersichtlicheren Datenlage kann z.B. ein digitaler Zwilling der Fabrik analysiert werden. Hierzu kann beispielsweise "Plant Simulation" genutzt werden. Damit kann ein digitales Abbild der Fertigung erzeugt werden, das alle wesentlichen Zusammenhänge einer Fertigung in einem Modell vereint. Durch das Clustering werden nun statt allen Daten nur die ausgewählten Vertreter der Cluster geladen. Das Modell kann so mit valider Datenbasis mit Optimierungsalgorithmen verbessert werden. Ansatzpunkte sind hier z.B. die Anzahl der Werker, Maschinen und AGVs, die Produktreihenfolge oder die Maschinenanordnung. Anschließend können die aus dem Modell gewonnenen Erkenntnisse an der realen Fertigung umgesetzt werden.

In einer weiteren vorteilhaften Ausführungsform wird die Optimierung iterativ durchgeführt. Um diese Methode noch effizienter und besser zu machen, kann für die Auslegung des digitalen Zwillings ein Optimierungsalgorithmus eingesetzt werden. Dazu wird ein Optimierungstool (z.B. "HEEDS"), das viele Optimierungsalgorithmen enthält, mit einem Produktions-Simulationsprogramm (z.B. "Plant Simulation") verbunden. Dabei werden die Parameter im Modell (z.B. Anzahl AGVs, Produktreihenfolge, Stationsauswahl, ...) vom Optimierungsalgorithmus vorgegeben. Nach dem Simulationsdurchlauf werden die Ergebnisse an den Optimierer übergeben, und dieser kann mit den neuen Erkenntnissen neue Parameterwerte festlegen. So werden automatisiert eine große Anzahl an Versuchen durchgeführt, um am Ende ein optimales Ergebnis für den digitalen Zwilling zu bekommen. Diese Erkenntnisse können dann auf die reale Fertigung angewendet werden.

In einer weiteren vorteilhaften Ausführungsform wird für die Einteilung in Cluster ein zufälliger Datenpunkt gewählt, es werden neue Datenpunkte innerhalb der zumindest ersten maximalen Distanz vom zufälligen Datenpunkt gesucht, aus diesen Datenpunkten wird ein neuer Cluster definiert, ausgehend von den neuen Datenpunkten werden weitere neue Datenpunkte, die noch nicht zum Cluster gehören, innerhalb der zumindest ersten maximalen Distanz von den jeweiligen neuen Datenpunkten dem Cluster hinzugefügt, und es wird der letzte Schritt wiederholt, bis keine neuen Datenpunkte mehr gefunden werden. Sind alle Punkte im Cluster gefunden, wird ein neuer zufälliger, noch ungeclusterter Punkt ausgewählt und der ganze Ablauf beginnt von neuem.

In einer weiteren vorteilhaften Ausführungsform wird eine maximale Ausdehnung festgelegt, die ein Cluster aufweisen darf. Auf diese Weise kann verhindert werden, dass zufällig doch alle Punkte in einem Cluster landen, oder auch nur, dass Unterschiede zwischen Produkten an einem Clusterrand zu denen am entgegengesetzten Clusterrand zu groß werden.

In einer weiteren vorteilhaften Ausführungsform wird zumindest die erste Eigenschaft der Produkte aus einem System der Fabrik ausgelesen. Auf diese Weise kann der Datensatz mit den Produkteigenschaften z.B. direkt aus einem ERP- ("Enterprise Resource Planning") oder MES-("Manufacturing Execution System") System der Fabrik stammen. Ein automatisches Einlesen der Daten über ein entsprechendes Interface ist insbesondere deshalb von Vorteil, da ein solcher Datensatz durchaus viele tausend Einträge enthalten kann.

In einer weiteren vorteilhaften Ausführungsform gibt die erste Eigenschaft den Weg des Produktes durch die Fabrik während der Herstellung wieder. Ein solcher Weg ist also z.B.: Station 1 - Station 17 - Station 20 - Station 45 - Zwischenlagerung - Station 57 - Verpacken - Versand usw. Diese Produktionsreihenfolge kann durch eine einfachere Zeichenkette dargestellt werden, also beispielsweise "S1 S17 S20 S45 ..." oder für ein anderes Produkt "S2 S8 S5 S9 ...". Für die Untersuchung der Ähnlichkeit zweier Produkte kann dann die Distanz der entsprechenden Zeichenketten berechnet werden, d.h. wie viele Schritte nötig sind, um von einer zur anderen zu gelangen.

In einer weiteren vorteilhaften Ausführungsform gibt die erste Eigenschaft die benötigten Materialien für die Herstellung des Produktes wieder. Dabei können die benötigten Materialien beispielsweise durch eine Materialnummer dargestellt werden, sodass sich Zeichenketten wie z.B. "1854 4589 1879 6587 ..." ergeben. Mit diesen wird dann wieder - wie beschrieben - anhand zumindest der ersten maximalen Distanz festgelegt, welche Produkte so ähnlich zueinander sind, dass sie zu einem Cluster zusammengefasst werden.

Im Folgenden wird die Erfindung anhand der in den Figuren dargestellten Verfahrensschritte eines Ausführungsbeispiels näher beschrieben und erläutert.

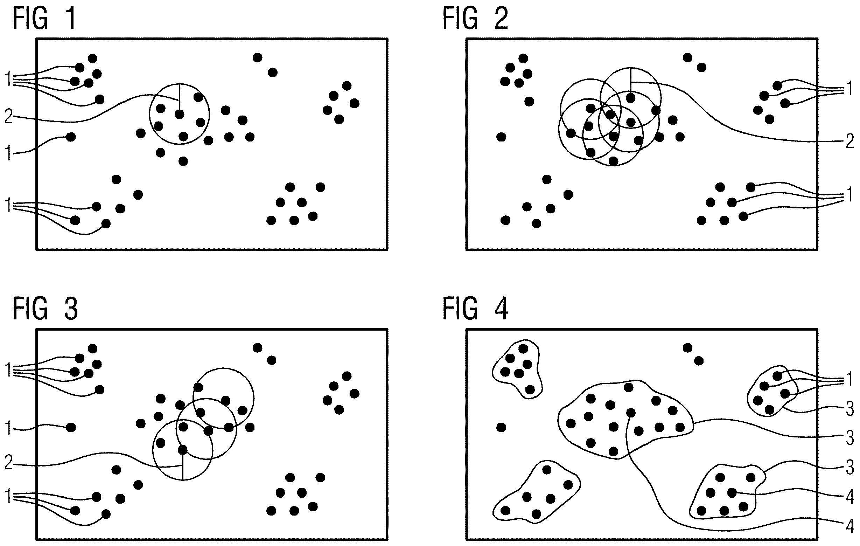

FIG 1 zeigt eine Verteilung von Datenpunkten 1, von denen bei einer vorteilhaften erfindungsgemäßen Lösung zunächst ein zufälliger Datenpunkt ausgewählt wird. Zu diesem Punkt werden neue Datenpunkte 1 ("Nachbarpunkte") gesucht, die maximal die erste maximale Distanz 2 entfernt sind. Dazu ist in der Figur ein Kreis mit einem Radius von der ersten maximalen Distanz 2 eingezeichnet. Alle Punkte, die in diesem Kreis liegen, sind Nachbarpunkte, aus denen ein neuer Cluster 3 definiert wird. An dieser Stelle ist es möglich, dass der neue Cluster 3 nur dann als solcher definiert wird, wenn er eine minimale Anzahl von Datenpunkten 1 erreicht. Es ist aber auch möglich, erst wiederholt weitere neue Datenpunkte 1 zu suchen und am Ende zu schauen, ob der Cluster 3 die minimale Anzahl von Datenpunkten 1 erreicht hat.

Die Lokalisierung eines Datenpunktes 1 in der Darstellung kann beispielsweise horizontal von der Produktionsreihenfolge als einer ersten Eigenschaft und vertikal von den benötigten Materialien als einer zweiten Eigenschaft erfolgen. Es ist möglich, horizontal eine erste maximale Distanz 2 und vertikal eine zweite maximale Distanz festzulegen, wobei Nachbarpunkte dann innerhalb eines Ovals oder Rechtecks anstelle eines Kreises gesucht werden könnten. Ebenso ist es möglich, bei Verwendung lediglich einer ersten maximalen Distanz 2 sowohl für die erste als auch die zweite Eigenschaft Nachbarpunkte innerhalb eines Quadrates anstelle eines Kreises zu suchen.

FIG 2 zeigt, wie anschließend für alle gefundenen Nachbarpunkte ebenfalls Nachbarpunkte ("weitere neue Datenpunkte") gesucht werden, die eine kleinere Distanz zu diesen haben als die erste maximale Distanz 2. Werden dort neue, noch nicht geclusterte Datenpunkte 1 gefunden (ggf. auch, wenn es weniger Punkte sind als die minimale Anzahl von Datenpunkten für einen Cluster), werden sie zum Cluster hinzugefügt.

FIG 3 zeigt, wie für die weiteren neuen Datenpunkte ebenfalls wieder Nachbarpunkte gesucht werden, bis nur noch Randpunkte existieren, wobei "Randpunkte" keine Nachbarpunkte haben, die noch nicht im Cluster sind. Sind alle Punkte im Cluster 3 gefunden (und es gibt also nur noch Randpunkte), wird ein neuer zufälliger, noch ungeclusterter Datenpunkt 1 ausgewählt und der ganze Ablauf beginnt von neuem, bis alle Datenpunkte 1 zu einem Cluster 3 zugeordnet sind oder ggf. nicht zu einem Cluster 3 zusammengefasst worden sind, falls sie nicht die minimale Anzahl für ein Cluster 3 erreicht haben. Es ist auch möglich, die Zuordnung von (weiteren) neuen Datenpunkten zu einem Cluster 3 abzubrechen, wenn der Cluster 3 eine maximale Ausdehnung erreicht haben sollte, damit sich die Eigenschaften von Produkten, die Datenpunkten 1 an z.B. gegenüberliegenden Rändern des Clusters 3 entsprechen, nicht zu sehr unterscheiden.

FIG 4 zeigt den Zustand nach vollständiger Clusterung (fast) aller Datenpunkte 1. Entstanden sind fünf Cluster 3 sowie drei Datenpunkte 1, die nicht einem Cluster 3 zugeordnet worden sind, da sie die minimale Anzahl für einen Cluster 3 nicht erreicht haben.

Das Ergebnis des Clusterings sind Produktgruppen, die nach unterschiedlichen Eigenschaften ähnlich untereinander sind. So kann aus jedem Cluster 3 ein Vertreter 4 ausgewählt und mit sehr wenig Datenverlusten das Layout der Fabrik optimiert werden, da sich die anderen Produkte in diesem Cluster 3 aufgrund der ähnlichen Eigenschaften sehr ähnlich verhalten würden. Die Optimierung erfolgt dabei anhand zumindest eines Parameters wie beispielsweise die Anzahl der Werker, der Maschinen und/oder der AGVs ("Automated Guided Verhicles"), die Produktreihenfolge und/oder die Maschinenanordnung.

Zusammenfassend betrifft die Erfindung ein Verfahren zur Optimierung eines Layouts einer Fabrik. Die Erfindung betrifft weiter ein Computerprogramm zur Durchführung eines derartigen Verfahrens sowie ein Computerprogrammprodukt mit einem derartigen Computerprogramm. Um ein im Vergleich zum Stand der Technik verbessertes Verfahren zur Optimierung eines Layouts einer Fabrik anzugeben, das insbesondere die Nachteile bisheriger Verfahren bei einer großen Produkt- und/oder Materialvarianz reduziert, wird ein Verfahren vorgeschlagen, wobei die Produkte zumindest eine erste Eigenschaft aufweisen, die als Zeichenkette darstellbar ist, wobei die Produkte durch jeweils einen Datenpunkt in Abhängigkeit von zumindest der ersten Eigenschaft repräsentiert werden, wobei zumindest eine erste maximale Distanz von einem Datenpunkt in Abhängigkeit von zumindest der ersten Eigenschaft festgelegt wird, wobei die Datenpunkte zumindest anhand der ersten maximalen Distanz in Cluster eingeteilt werden, wobei von zumindest einem Cluster zumindest ein Datenpunkt als Vertreter für den jeweiligen Cluster ausgewählt wird und wobei anhand zumindest eines Vertreters das Layout in Bezug auf zumindest einen Parameter optimiert wird.

## Patentansprüche

1. Verfahren zur Optimierung eines Layouts einer Fabrik, in der Produkte hergestellt werden,
wobei die Produkte zumindest eine erste Eigenschaft aufweisen, die als Zeichenkette darstellbar ist,
wobei die Produkte durch jeweils einen Datenpunkt (1) in Abhängigkeit von zumindest der ersten Eigenschaft repräsentiert werden,
wobei zumindest eine erste maximale Distanz (2) von einem Datenpunkt (1) in Abhängigkeit von zumindest der ersten Eigenschaft festgelegt wird,
wobei die Datenpunkte (1) zumindest anhand der ersten maximalen Distanz (2) in Cluster (3) eingeteilt werden,
wobei von zumindest einem Cluster (3) zumindest ein Datenpunkt (1) als Vertreter (4) für den jeweiligen Cluster (3) ausgewählt wird und
wobei anhand zumindest eines Vertreters (4) das Layout in Bezug auf zumindest einen Parameter optimiert wird.

2. Verfahren nach Anspruch 1, wobei eine minimale Anzahl von Datenpunkten (1) festgelegt wird, die ein Cluster (3) aufweisen muss.

3. Verfahren nach Anspruch 1 oder 2, wobei zumindest die erste maximale Distanz (2) als eine Levenshtein-Distanz oder eine Damerau-Levenshtein-Distanz definiert wird.

4. Verfahren nach einem der vorherigen Ansprüche, wobei das Layout in einem digitalen Abbild der Fabrik dargestellt wird.

5. Verfahren nach einem der vorherigen Ansprüche, wobei die Optimierung iterativ durchgeführt wird.

6. Verfahren nach einem der vorherigen Ansprüche, wobei für die Einteilung in Cluster (3) ein zufälliger Datenpunkt (1) gewählt wird,
neue Datenpunkte (1), innerhalb der zumindest ersten maximalen Distanz (2) vom zufälligen Datenpunkt (1) gesucht werden, aus diesen Datenpunkten (1) ein neuer Cluster (3) definiert wird, ausgehend von den neuen Datenpunkten (1) weitere neue Datenpunkte (1), die noch nicht zum Cluster (3) gehören, innerhalb der zumindest ersten maximalen Distanz (2) von den jeweiligen neuen Datenpunkten (1) dem Cluster (3) hinzugefügt werden,
der letzte Schritt wiederholt wird, bis keine neuen Datenpunkte (1) mehr gefunden werden.

7. Verfahren nach einem der vorherigen Ansprüche, wobei eine maximale Ausdehnung festgelegt wird, die ein Cluster (3) aufweisen darf.

8. Verfahren nach einem der vorherigen Ansprüche, wobei zumindest die erste Eigenschaft der Produkte aus einem System der Fabrik ausgelesen wird.

9. Verfahren nach einem der vorherigen Ansprüche, wobei die erste Eigenschaft den Weg des Produktes durch die Fabrik während der Herstellung wiedergibt.

10. Verfahren nach einem der vorherigen Ansprüche, wobei die erste Eigenschaft die benötigten Materialien für die Herstellung des Produktes wiedergibt.

11. Computerprogramm zur Durchführung eines Verfahrens nach einem der vorherigen Ansprüche bei Ablauf in zumindest einer Recheneinheit.

12. Computerprogrammprodukt, auf dem zumindest ein Computerprogramm nach Anspruch 11 gespeichert ist.
